# EUROPEAN PATENT SPECIFICATION

(11) **EP 3 176 142 B1**
(45) Date of publication and mention of the grant of the patent: **01.04.2020**
(21) Application number: 16175558.2
(22) Date of filing: 21.06.2016
(51) Int. Cl.: C04B 35/468, C01G 23/00, C04B 35/622, C04B 35/624, C04B 35/632, C04B 35/634, H01L 41/187, H01L 41/318

(54) **PRECURSOR SOLUTION AND METHOD FOR THE PREPARATION OF A LEAD-FREE PIEZOELECTRIC MATERIAL**
VORLÄUFERLÖSUNG UND VERFAHREN ZUR HERSTELLUNG EINES BLEIFREIEN PIEZOELEKTRISCHEN MATERIALS
SOLUTION DE PRÉCURSEUR ET PROCÉDÉ POUR LA PRÉPARATION D'UN MATÉRIAU PIÉZOÉLECTRIQUE EXEMPT DE PLOMB

(30) Priority: 01.12.2015 IT UB20156052
(43) Date of publication of application: 07.06.2017
(73) Proprietor: STMicroelectronics S.r.l., 20864 Agrate Brianza (MB) (IT)
(72) Inventor: CIMMINO, Angela, 81100 CASERTA (IT); SALZILLO, Giovanna, 81030 TEVEROLA (IT); CASUSCELLI, Valeria, 80128 NAPOLI (IT); DI MATTEO, Andrea, 80131 NAPOLI (IT)
(74) Representative: Casciano, Lidia Giulia Rita

(56) References cited:
- TUNG-HSIEN HSIEH ET AL: "A study on the synthesis of (Ba,Ca)(Ti,Zr)O nano powders using Pechini polymeric precursor method", CERAMICS INTERNATIONAL, ELSEVIER, AMSTERDAM, NL, vol. 38, no. 1, 1 August 2011 (2011-08-01) , pages 755-759, XP028118693, ISSN: 0272-8842, DOI: 10.1016/J.CERAMINT.2011.08.001 [retrieved on 2011-08-09]
- GUANGQING KANG ET AL: "(1 - x)Ba(Zr0.2Ti0.8)O3-x(Ba0.7Ca0.3)TiO3 Ferroelectric Thin Films Prepared from Chemical Solutions", JOURNAL OF THE AMERICAN CERAMIC SOCIETY., 1 October 2011 (2011-10-01), pages n/a-n/a, XP055289467, US ISSN: 0002-7820, DOI: 10.1111/j.1551-2916.2011.04877.x
- HONGGUANG WANG ET AL: "Infrared optical properties of ferroelectric 0.5BaZr0.2Ti0.8O3-0.5Ba0.7Ca0.3TiO3 thin films", CERAMICS INTERNATIONAL., vol. 41, no. 1, 1 January 2015 (2015-01-01), pages 475-480, XP055289561, NL ISSN: 0272-8842, DOI: 10.1016/j.ceramint.2014.08.094
- KLARA CASTKOVA ET AL: "Chemical Synthesis, Sintering and Piezoelectric Properties of Ba 0.85 Ca 0.15 Zr 0.1 Ti 0.9 O 3 Lead-Free Ceramics", JOURNAL OF THE AMERICAN CERAMIC SOCIETY., vol. 98, no. 8, 8 May 2015 (2015-05-08), pages 2373-2380, XP055289661, US ISSN: 0002-7820, DOI: 10.1111/jace.13642
- GAO L N ET AL: "Study of dielectric characteristics of graded Ba1-xCaxZr0.05Ti0.95O3 thin films grown by a sol-gel process", JOURNAL OF SOL-GEL SCIENCE AND TECHNOLOGY, KLUWER ACADEMIC PUBLISHERS, BO, vol. 45, no. 1, 14 November 2007 (2007-11-14), pages 51-55, XP019577711, ISSN: 1573-4846
- WEIWEI WU ET AL: "Electrospinning lead-free 0.5Ba(Zr0.2Ti0.8)O3-0.5(Ba0.7Ca0.3)TiO3 nanowires and their application in energy harvesting", JOURNAL OF MATERIALS CHEMISTRY A: MATERIALS FOR ENERGY AND SUSTAINABILITY, vol. 1, no. 25, 1 January 2013 (2013-01-01), page 7332, XP055289278, GB ISSN: 2050-7488, DOI: 10.1039/c3ta10792b
- JALALIAN A ET AL: "Ferroelectric and Ferromagnetic Nanofibers: Synthesis, Properties and Applications", JOURNAL OF PHYSICS: CONFERENCE SERIES, INSTITUTE OF PHYSICS PUBLISHING, BRISTOL, GB, vol. 352, no. 1, 5 March 2012 (2012-03-05) , page 12006, XP020220205, ISSN: 1742-6596, DOI: 10.1088/1742-6596/352/1/012006
- TOYODA M ET AL: "Preparation and characterization of (Ba,Ca)(Ti,Zr)O3 thin films through sol-gel processing", JOURNAL OF SOL-GEL SCIENCE AND TECHNOLOGY, SPRINGER, NEW YORK, NY, US, vol. 16, no. 1-2, 1 October 1999 (1999-10-01), pages 7-12, XP002278132, ISSN: 0928-0707, DOI: 10.1023/A:1008700802301

## Description

The present invention relates to a precursor solution and to a method for the preparation of a piezoelectric material that is free from lead and from chemical compounds that are mutagenic and carcinogenic for humans and toxic for the environment.

Piezoelectric materials are materials that are able to expand or contract when a voltage is applied (electrostrain effect), and conversely to generate a voltage if they are subjected to a pressure (piezoelectric effect).

They consequently constitute a very important class of materials that are able to convert mechanical energy into electrical energy, and vice versa. They have been in fact widely used in products in the field of energy conversion, such as actuators and sensors, and are widespread in common applications but also in advanced technologies, performing a fundamental role in today's society.

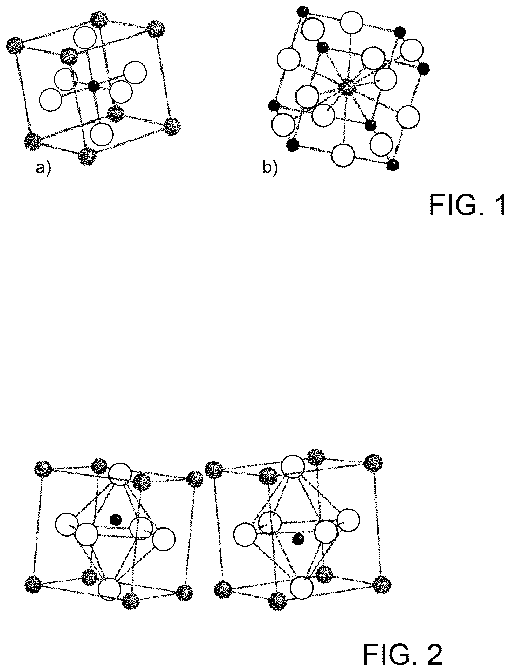

Piezoelectric materials have a crystalline structure of the perovskite type. Mineral perovskite is a calcium titanate, having the chemical formula CaTiO₃. The family of perovskite oxides has a generic composition ABO₃, where the element A (represented in grey in Figures 1A and 1B) is 12-fold co-ordinated with respect to oxygen (shown in white in Figures 1A and 1B) and the element B (shown in black in Figures 1A and 1B) presents octahedral co-ordination with oxygen. The sites A are positioned at the corners of a cube, the site B is at the centre of the cube, and the oxygen atoms are positioned at the centre of each face. Alternatively, the structure could be represented with the sites B at the corners of the cube, the site A at the centre of the cube, and the oxygen atoms at the midpoint of each edge (Figures 1A and 1B, respectively).

The perovskite-type structure shows excellent tolerance to variations in its composition and to possible distortions of the final material thanks to its capacity to adapt to any misalignment in the balance between the lengths of the AO and BO bonds, thus enabling the existence of a large number and variety of stoichiometric compounds.

The distortions, for example tetragonal (Figure 2), orthorhombic, rhombohedral, and monoclinic distortions, in fact give rise to changes in the symmetry of the crystal, where one or more cations displace from positions with high symmetry in the lattice, this resulting in a ferroelectric or anti-ferroelectric behaviour. In other words, a spontaneous polarization is caused when the centre of the positive charge and the centre of the negative charge within the unitary cell do not coincide.

However, in a ferroelectric material spontaneous polarization is necessary but not sufficient in so far as a re-orientation of polarization by an electrical field is also required.

The most widespread family of piezoelectric materials is certainly that of lead-zirconate-titanate (PZT) ceramics, thanks to the high values of the piezoelectric coefficient, of the dielectric constants, and of the coupling factors. These properties have been observed in compositions in the proximity of a morphotropic-phase boundary (MPB). The MPB presents a slight dependence upon temperature so that the stability of the properties is reached over a wide temperature range.

However, since PZT contains a large amount of toxic lead, the use of these materials is subject to stringent standards for environmental reasons.

Consequently, it is desirable to develop a material that has a lower environmental impact and is lead-free and that presents a piezoelectric coefficient comparable to that of PZT (200-710 pC/N).

In the last few years, various lead-free systems have consequently been investigated, amongst which barium titanate, titanates of bismuth and an alkaline metal, and niobates.

Wenfeng Liu et al., in "Large Piezoelectric Effect in Pb-free Ceramics", Phys. Rev. Letters, (2009), 103, 257602 and in US20110037015, studied the ceramic (1-α) Ba(Zr_{0.2}Ti_{0.8})O₃-α(Ba_{0.7}Ca_{0.3})TiO₃ (BZT-αBCT), where α is a molar fraction comprised between 0 and 1, obtained using a conventional solid-state reaction method.

The above authors reported that the existence of a cubic-rhombohedral-tetragonal (C-R-T) triple point in the phase diagram located at x = 0.32 and T = 57°C in materials with high piezoelectricity, with values comparable to those of piezoelectric transducers made of lead zirconate titanate (PZT) with high sensitivity or high polarization. In particular, the authors showed that ceramics having a perovskite structure and a complex composition of the type 0.5Ba(Ti_{0.8}Zr_{0.2})O₃-0.5(Ba_{0.7}Ca_{0.3})TiO₃ (BZT-0.5BCT) have a high piezoelectric coefficient d₃₃ of up to 620 pC/N at a relatively low Curie temperature (Tc ∼ 93°C), whereas BZT-BCT composite ceramics present a higher Tc of approximately 114°C for x = 0.53.

Single-crystal BZT-BCT composites at the morphotropic-phase boundary (MPB) have shown a high piezoelectric coefficient d₃₃ of approximately 1500 to 2000 pC/N. By optimising the poling conditions for ceramic composites of the Ba(Ti_{0.8}Zr_{0.2})O₃-0.5(Ba_{0.7}Ca_{0.3})TiO₃ type, a high piezoelectric coefficient d₃₃ has been observed of approximately 630 pC/N, with a planar electromechanical factor of 56%.

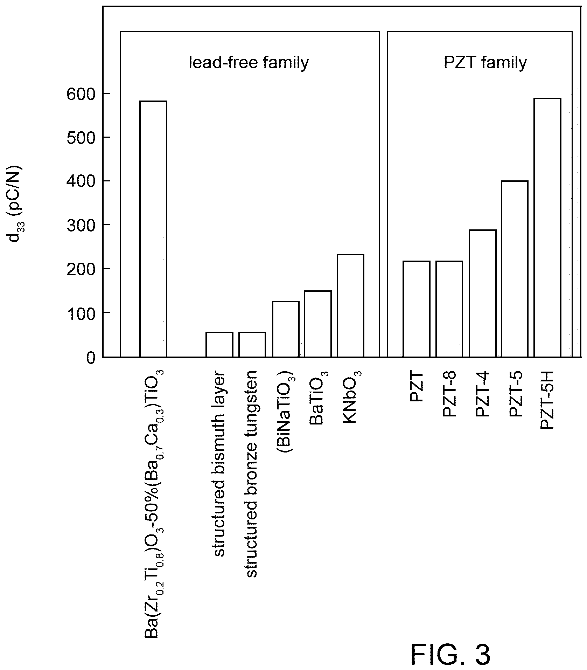

Figure 3 presents a comparison between the piezoelectric coefficient d₃₃ of a BZT-0.5BCT material, the piezoelectric coefficients of other lead-free piezoelectric materials, and those of the materials of the PZT family. As emerges clearly from the figure, not only do lead-free BZT-BCT materials have piezoelectric coefficients at least twice those of other piezoelectric materials, but moreover the piezoelectric properties are better than those of the majority of PZT materials.

However, the technique of preparation by means of conventional solid-state reaction is quite complex. There have thus been developed techniques that are simpler and less costly and that enable a better control over the stoichiometry of the final compound, for example sol-gel techniques.

Using the sol-gel technique, Xianghua Liu et al., as described in "Preparation and Characterization of (Ba0.88Ca0.12)(Zr0.12Ti0.88)O3 Powders and Ceramics Produced by Sol-Gel Process", Advanced Materials Research (2010), 148-149, 1062-1066, prepared lead-free BZT-BCT ceramics, with a maximum piezoelectric coefficient d₃₃ of approximately 400 pC/N. A system with a slight variation in the composition of (Ba_{0.88}Ca_{0.12})(Zr_{0.12}Ti_{0.88})O₃ was moreover prepared, the piezoelectric coefficient d₃₃ of which drastically dropped to 215 pC/N.

The majority of thin films of ferroelectric ceramics may be deposited on silicon substrates coated with platinum, of the Pt(111)/Ti/SiO₂/Si(100) type, with a composition close to the morphotropic phase boundaries using various deposition methods: sputtering pulsed-laser ablation, screen-printing, metal-organic chemical vapour deposition, and methods of sol-gel deposition and chemical solution deposition (CSD).

Chemical solution deposition (CSD), and in particular deposition of solutions obtained using the sol-gel technique, affords some advantages on account of the low temperatures that may be employed, the homogeneity of composition, the possibility of covering extensive surface areas of the substrate, and the simplicity of the process as compared to other methods, such as physical-deposition methods.

The sol-gel technique consists in mixing metal-organic compounds (principally metal alkoxides) in an organic solvent. The subsequent addition of water generates two reactions: one of hydrolysis, and one of condensation.
M(OR)ₙ + xH₂O → M(OH)ₓ(OR)ₙ₋ₓ + xROH (hydrolysis)
M-OR + MOH → M-O-M + R-OH or
M-OH + M-OH → M-O-M + H-OH (condensation)

These reactions lead to the formation of a three-dimensional lattice of particles.

The sol precursor may then be dried and calcined to obtain a crystalline ceramic or alternatively may be stabilized via a fine control of the competitive reactions, and the reagents may be used for producing thin films.

In the literature, various sol-gel syntheses of BZT-BCT have been proposed that use the following reagents.

| **Ba source** | **Ca source** | **Ti source** | **Zr source** | **Solvent / Chelating agent** | **El./piezoel. characteristics** |
|---|---|---|---|---|---|
| Met. Ba | Ca (NO₃) ₂ | TiIP | ZrIP | 2-MOE | ε: ∼ 3000 |
| | | | | | tanδ: 0.06 |
| | | | | | Pᵣ: 15.8 µC/cm² |
| | | | | | E_{c}: 58 kV/cm |
| | | | | | d₃₃ : 71.7 pm/V |
| BaAc | CaAc | TiBut | ZrON | ETOH/H₂0 HAc | Pᵣ: 22.15 mC/cm |
| | | | | | E_{c}: 68.06 kV/cm |
| BaAc | Ca-Ac | TiIP | Zrn-P | 2-MOE HAc | ε: 457 |
| | | | | | tanδ:0.031 |
| | | | | | Dₘₐₓ :0.86 nm |
| | | | | | J : ∼ 6 × 10 and ⁵ A/ cm |
| | | | | | P :141 µC/ m² K |
| | | | | | F_{d}: 0.50 × 10 and ⁵ Pa^{-1/2} |
| BaAc | Ca-Ac | TiIP | Zr*n*-P | 2-MOE HAc | d₃₃ : 113.6 pm/V |

| | | | | | |
|---|---|---|---|---|---|
| (BaAc = barium acetate; CaAc = calcium acetate; TiIP = titanium isopropoxide; ZrIP = zirconium isopropoxide; ZrON = zirconium oxynitrate; ZrAcAc = zirconium acetylacetate; TiBut = titanium butoxide; Zrn-P = zirconium n-propoxide; HAc = acetic acid; 2-MOE = 2-methoxy ethanol; ETOH = ethanol; AcAc = acetylacetone) | | | | | |

As may be noted, the most widely employed sol-gel systems are those that use 2-methoxyethanol (2-MOE) as solvent. However, 2-methoxyethanol is highly toxic for humans.

Furthermore, the systems that do not make use of 2-MOE lead to the formation of unstable sol solutions that gel in a short time, rendering difficult storage of the solution and its subsequent use in the deposition of piezoelectric thin films.

Methods for the preparation of a precursor solution for the preparation of BZT-BCT are disclosed in Hsieh et al, "A study on the synthesis of (Ba,Ca) (Ti,Zr)O nano powders using Pechini polymeric precursor method", CERAMICS INTERNATIONAL, ELSEVIER, AMSTERDAM, NL, vol. 38, no. 1 and in Wang et al, "Infrared optical properties of ferroelectric 0.5BaZr0.2Ti0.8O3-0.5Ba0.7Ca0.3TiO3 thin films", CERAMICS INTERNATIONAL., NL, (20150101), vol. 41.

Consequently, it is desirable to improve the sol-gel process for the synthesis of piezoelectric materials so that it will not make use of solvents that are carcinogenic and mutagenic for humans and toxic for the environment and will lead to formation of sol solutions that are stable over time and do not cause formation of gel.

The aim of the present invention is consequently to provide a new precursor solution and a new method for the synthesis of piezoelectric materials of the BZT-BCT type that does not make use of solvents that are carcinogenic and mutagenic for humans and toxic for the environment and that generates a clear and stable sol solution.

The above aim is achieved by the present invention in so far as it regards a precursor solution according to claim 1, a method for the preparation of said precursor solution according to claim 7 and a method for the preparation of a film of a piezoelectric material according to claim 8.

The present invention will now be described in detail with reference to the annexed drawings, wherein:
- Figure 1 illustrates the unit of the cell of an ideal cubic perovskite of the ABO₃ type;
- Figure 2 illustrates the tetragonal ferroelectric distortion of the perovskite structure in the two polarization states;
   sample of BZT-0.5BCT (EG-HAc) from room temperature to 1200°C, measured at a heating rate of 10°C/min with an airflow of 20.0 mL/ min;
- Figure 6 illustrates the XRD spectrum of a BZT-0.5BCT powder precursor obtained by sintering at 950°C of a precursor solution containing EG as solvent and HAc as chelating agent;
- Figure 7 illustrates the DTA thermogram for dried BZT-0.5BCT (EG-AcAc) from room temperature to 1200°C, measured at a heating rate of 10°C/min in air, with an airflow of 20.0 mL/ min;
- Figure 8 illustrates the XRD spectrum of a BZT-0.5BCT powder precursor obtained by sintering at 950°C of a precursor solution containing EG as solvent and AcAc as chelating agent;
- Figure 9 illustrates a SEM image of a thin film obtained from a precursor solution comprising ethylene glycol as solvent and acetic acid as chelating agent;
- Figure 10 illustrates the XRD spectrum of a thin film obtained from a BZT-BCT precursor solution sintered at 800°C; and
- Figure 11 illustrates the XRD spectrum of a monolayer thin film obtained from a BZT-0.5BCT precursor solution sintered at 800°C, with a seed layer.

According to one aspect of the present disclosure, a precursor solution as defined in claim 1 is provided for the preparation of a ceramic of the BZT-αBXT type, where X is selected from Ca, Sn, Mn, and Nb, and α is a molar fraction selected in the range between 0.10 and 0.90.

By the term "precursor solution" is understood a mixture containing all the components used to form a BZT-BXT ceramic following upon appropriate treatment.

### Metal compounds

In the present text, by "barium precursor compound", "calcium precursor compound", "tin precursor compound", "manganese precursor compound", "niobium precursor compound", "zirconium precursor compound", and "titanium precursor compound" are understood compounds in which an organic group is bonded, respectively, to the metal element Ba, Ca, Sn, Mn, Nb, and Zr and Ti, through an oxygen or nitrogen atom of the organic group. The choice of the metal precursors determines the nature of the cations of the sites A and B of the perovskite structure.

The precursor compounds of Ca, Ba, Zr, Ti, Sn, Nb, and Mn are selected from the group consisting of metal alkoxides, metal-diol complexes, metal-thiol complexes, metal carboxylates, metal-3-diketonate complexes, metal-3-diketoester complexes, metal-3-iminoketo complexes, metal-amine complexes, more in particular, metal alkoxides, and their partial hydrolytes and metal carboxylates.

Examples of a precursor compound of Ca include acetates, such as calcium acetate (Ca(OAc)₂), and alkoxides, such as calcium diisopropoxide (Ca(OiPr)₂).

Examples of a precursor compound of Ba include acetates, such as barium acetate (Ba(OAc)₂), and alkoxides, such as barium diisopropoxide (Ba(OiPr)₂).

Examples of a precursor compound of Ti comprise alkoxides, such as titanium tetraethoxide (Ti(OEt)₄), titanium tetraisopropoxide (Ti(OiPr)₄), titanium tetra-n-butoxide (Ti(OnBu)₄), titanium tetraisobutoxide (Ti(OiBu)₄), titanium tetra-t-butoxide (Ti(OtBu)₄), or titanium dimethoxy diisopropoxide (Ti(OMe)₂(OiPr)₂), more in particular titanium tetrabutoxide and titanium isopropoxide.

The hydration enthalpy for titanium isopropoxide is considerably higher than that of titanium tetrabutoxide (EH = -64.9 kJ/mol), and this may be put down to its being a monomeric species (i.e., there are no oligomeric bonds between the alkoxide molecules).

Since titanium isopropoxide lacks oligomeric bonds, the monomers may be attacked from all sides by water without first undergoing de-polymerization.

Titanium tetrabutoxide is, instead, trimeric (i.e., the fundamental unit is formed by three identical monomers bonded in an oligomeric way). Consequently, a considerable amount of energy is consumed to break the oligomeric bonds before hydrolysis may start, leading to a low hydration enthalpy (EH = -19.3 kJ/mol). Consequently, without the presence of chelating agents even in small amounts, titanium butoxide is hydrolytically more stable, and hence less reactive, than titanium isopropoxide, which has a much more negative enthalpy of hydrolysis and tends to decompose in the presence of even small amounts of water.

In any case, with high values of chelating agent as compared to the values of titanium and zirconium, titanium isopropoxide becomes more stable than titanium butoxide, probably on account of a more complete exchange of ligands.

Examples of precursor compounds of Zr are zirconium n-propoxide, zirconium tetraethoxide (Zr(OEt)₄), zirconium tetraisopropoxide (Zr(OiPr)₄), zirconium tetra-n-butoxide (Zr(OnBu)₄), zirconium tetraisobutoxide (Zr(OiBu)₄), zirconium tetra-t-butoxide (Zr(OtBu)₄), or zirconium dimethoxy diisopropoxide (Zr(OMe)₂(OiPr)₂), more in particular zirconium n-propoxide.

Examples of a precursor compound of Mn include manganese acetate.

Furthermore, examples of precursor compounds of Nb include niobium pentaethoxide.

Among precursor compounds of Ti and Zr particularly indicated are the alkoxides that are favoured on account of their high reactivity and capacity of formation of the desired phases at low reaction temperatures, whereas among the compounds of Ba and Ca carboxylates are favoured.

### Solvent

The choice of the solvent is linked to the desire to identify a means in which the compounds of Ba, Ca, Sn, Mn, Nb, and Zr and Ti are mutually compatible, but above all to the desire to obtain a clear and stable sol solution.

It has been found that the presence of residual water deriving from hydration of the metal compounds, from environmental humidity, or from residue in the solvents leads to precipitation of the gel in the sol solution, thus determining its instability.

It is consequently desired to reduce to the minimum the presence of residual water during the preparation of the gel solution.

It has been noted that the use of precursor compounds in association with a solvent selected from the group consisting of polyols, alcohols, carboxylic acids, esters, ketones, ethers, and their mixtures enables sol solutions to be obtained that remain clear and stable over time.

Other considerations in the choice of the solvent include their viscosity, availability, stability, and toxicity.

In what follows, by the term "polyol" is meant an alkyl compound, possibly branched, containing at least two carbon atoms and at least two OH groups.

In the precursor solution according to the invention, the solvent is selected from the group consisting of propylene glycol, ethylene glycol, and 1,3-propanediol, in particular propylene glycol and ethylene glycol.

Using a polyol as component of the solvent, the stability in conservation of the composition is increased.

Polyols, in addition to being able to co-dissolve the metal-organic compounds, also have a higher viscosity than the solvents commonly used in the prior art, enabling the production via spin-coating of thicker BZT-BXT films without cracks.

Optionally, a secondary solvent selected from ethanol, 1-butanol, 1-propanol, 2-propanol, 2-butanol, isobutyl alcohol, 1-pentanol, 2-pentanol, 2-methyl-2-pentanol, in particular ethanol and 1-butanol, acetic acid, n-butyric acid, x-methyl butyric acid, i-valeric acid, 2-ethyl butyric acid, 2,2-dimethyl butyric acid, 3,3-dimethyl butyric acid, 2,3-dimethyl butyric acid, 3-methylpentanoic acid, 4-methylpentanoic acid, 2-ethylpentanoic acid, 3-ethylpentanoic acid, 2,2-dimethylpentanoic acid, 3,3-dimethylpentanoic acid, 2,3-dimethylpentanoic acid, 2-ethylhexanoic acid, 3-ethylhexanoic acid, ethyl acetate, propyl acetate, n-butyl acetate, sec-butyl acetate, ter-butyl acetate, isobutyl acetate, n-amyl acetate, sec-amyl acetate, ter-amyl acetate, isoamyl acetate, acetone, methylethylketone, dimethyl ether or diethyl ether.

### Chelating agent

To stabilise the metal compounds upon decomposition, in particular the titanium and zirconium compounds, chelating agents must be used.

The chelating agents act both by physically surrounding the cation in solution (steric hindrance) and by binding directly thereto in order to reduce their chemical reactivity (inductive effect).

Examples of chelating agents are acetylacetone (2,2-pentanedione, or AcAc), acetic acid (HAc), glycerol, propylene glycol, diethanolamine, EDTA (ethylenediaminetetraacetic acid), and triethanolamine.

Acetylacetone substitutes some or all of the ligands of the alkoxide and, since the ligands of AcAc are not rapidly hydrolysable, the overall hydrolysis rate of the chelated sol is reduced. The amount of chelating agent has an effect on the hydrolysis rate, on the size of the particles, on the condensation process, and on formation of the perovskite phase. It has been shown that the ligands of AcAc remain tightly bound to the metal cation after hydrolysis and condensation, and high temperatures may be necessary for their complete removal: an excess of AcAc may cause failure of synthesis of material that presents a pure perovskite phase.

Also acetic acid (HAc) may be used for reducing the reactivity of titanium alkoxides. Gelling and precipitation in sols containing titanium alkoxides may be suppressed with the addition of moderate amounts of acetic acid. In any case, when the amount of acetic acid is high, insoluble species of acetate may form, thus preventing direct crystallisation in the perovskite phase and increasing the lack of homogeneity in the sol solution and hence in the film deposited thereby. Consequently, the selection of an appropriate amount of acetic acid in relation to the amount of titanium and zirconium may affect the production of homogeneous films when acetic acid is used as chelating agent.

### Further components

In addition, the present composition contains, as viscosizing agent with high molecular weight, a polyvinylpyrrolidone (PVP) and a polyethylene glycol.

Polyvinylpyrrolidone and polyethylene glycol are used for adjusting the viscosity of the solution in the composition and reducing or eliminating cracks in the film.

According to another aspect, a method is provided for preparation of a precursor solution for the production of a ceramic of the BZT-αBXT type, where X is selected from Ca, Sn, Mn, and Nb, and α is a molar fraction selected in the range between 0.10 and 0.90, the method comprising the steps of:
1) dissolving at least one precursor compound of barium and at least one precursor compound selected from the group consisting of a calcium compound, a tin compound, a manganese compound, and a niobium compound, in a solvent selected from the group consisting of a polyol and mixtures of a polyol and a secondary solvent selected from the group consisting of alcohols, carboxylic acids, esters, ketones, ethers, and their mixtures to obtain a first solution;
2) dissolving at least one anhydrous compound of titanium and at least one anhydrous compound of zirconium in a chelating agent to obtain a second solution; and
3) mixing said first and second solutions to obtain the precursor solution.

The precursor compounds of Ca and Ba, Zr, Ti, Sn, Nb, and Mn may each be dissolved separately in an own solvent, and the solutions thus obtained may then be mixed together.

Alternatively, in the preparation of the precursor solution, it is possible to prepare a first solution of Ba-Ca and a second solution of Ti-Zr, and then mix these two solutions to obtain a clear and stable precursor solution.

When alkoxides are used, during hydrolysis, these favour formation of M-O-M bonds, so helping to preserve the homogeneity of the precursor solution during the gelling process.

Even though metal alkoxides are very difficult to handle, are generally very sensitive, even to mere traces of humidity, and tend to decompose rapidly, they are used in CSD reactions on account of their capacity to hydrolyse and condense to form long chains of oligomers (porous three-dimensional metal-organic structures), which, after calcining, shrink to form xerogels (that are prevalently anhydrous and porous).

These porous xerogels create dense and crystalline films during the sintering (annealing) step. The guiding force in formation of the film is the reduction of the energy or the surface pressure on account of the capillary forces that cause contraction of the solid lattice.

When polyols are chosen as solvents, it is possible to minimize the effect of the residual water deriving from water of crystallisation of the starting compounds of Ca and Ba, Zr, Ti, Sn, Nb, and Mn and to stabilise the precursor solution, thus obtaining a stable and clear solution that may be stored for subsequent use.

According to a further non-inventive aspect, a piezoelectric material made of a ceramic of the BZT-αBXT type is provided, where X is selected from Ca, Sn, Mn, and Nb, and α is a molar fraction selected in the range between 0.10 and 0.90, said ceramic being obtained from a precursor solution described above.

In particular, the piezoelectric material may be in the form of film or powder and may be used instead of conventional PZTs, for example in applications such as sensors for airbags, fuel piezo-injectors, ignition sources for gas lighters, detonation sensors, angle sensors for motor vehicles, hard disks, ink-jet print heads, touch sensors for PC monitors, atomization sources for humidifiers and inhalers, smoke detectors, devices for cleaning jewellery and contact lenses, accelerometers, pollution detectors, flow meters, detectors of air bubbles in tubes, impact sensors, level indicators, micropositioning equipment, pressure sensors, nondestructive ultrasound cleaning devices, ultrasound degreasers, ultrasound grinders, welders, ultrasound apparatuses, dental appliances, nebulizers, ultrasound therapy, sonars, orientation systems, optical and acoustic microphones, speakers, tweeters, resonators, filters, microactuators for scanning electron microscopes and cameras, and non-volatile memories.

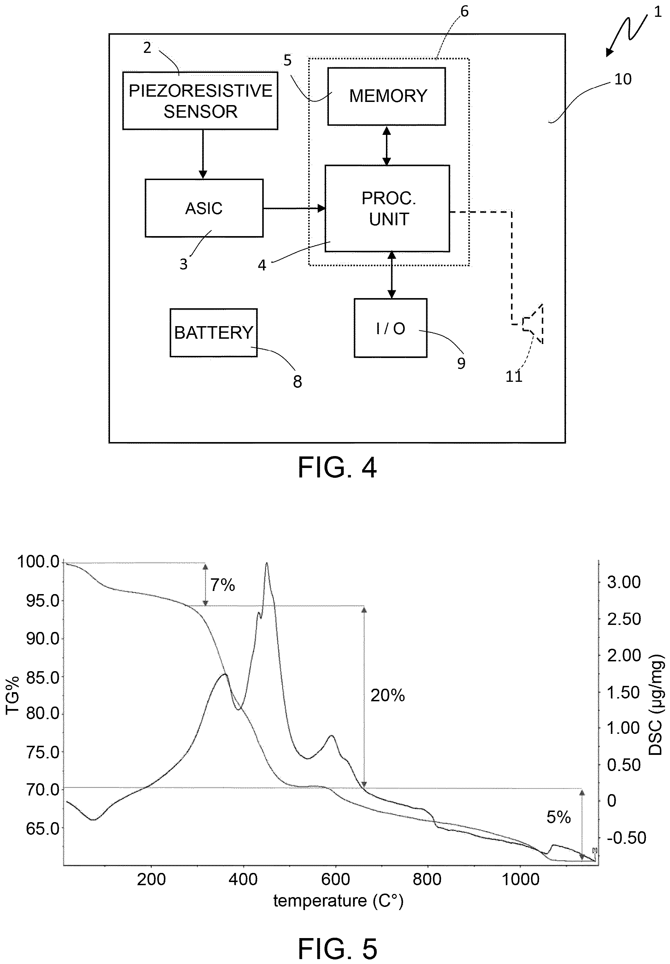

Figure 4 is a schematic illustration of an electronic apparatus 1 that uses a MEMS sensor 2 of a piezoelectric type.

The electronic apparatus 1 comprises, in addition to the MEMS device 2: an ASIC 3 connected to the MEMS device 2; a processing unit 4, for example a microprocessor, connected to the ASIC 5; a memory 5, connected to the processing unit 4; a battery 8 for supplying the various blocks of the electronic apparatus 1; and an input/output interface 9, which is also connected to the processing unit 4. Furthermore, a speaker 11 may be present for generating a sound on an audio output (not shown) of the electronic apparatus 1.

In a way known and not shown herein, the MEMS device 2 comprises a suspended region, for example a membrane, carrying a layer of piezoelectric material, as described above, and supplies, on an output, electrical signals correlated to the deformation of the suspended region. The ASIC 5 is electrically coupled to the MEMS device 2 so as to receive the electrical signals generated by the latter and supply to the outside world the values of the physical quantities detected as a result of the deformation of the MEMS device and/or of quantities correlated thereto.

Furthermore, the electronic apparatus 1 may be fixed to a supporting body 10, for example constituted by a printed circuit board.

According to yet another aspect of the invention, there is provided a method for the preparation of a film of a piezoelectric material made of a ceramic of the BZT-αBXT type, where X is selected from Ca, Sn, Mn, and Nb, and α is a molar fraction selected in the range between 0.10 and 0.90, said method comprising a step of deposition on a substrate of the precursor solution described above, a calcining step, and a sintering step.

In particular, the precursor solution may be applied by spin-coating on an appropriate substrate, for example a silicon substrate coated with platinum. Next, the solution is calcined and sintered (by annealing) at high temperatures in the presence of oxygen to obtain a homogeneous crystalline film.

In particular, the calcining step may be conducted at a temperature of between 300°C and 450°C, and the sintering step at a temperature of 550-850°C. This enables thin films to be obtained that are dense and without cracks. This cycle of deposition, calcining, and sintering may be repeated a number of times to obtain films of different thicknesses stacked on one another.

Possibly, prior to the calcining step, a drying step may be carried out to remove the solvent, in particular at a temperature of between 100°C and 200°C.

Where it is instead necessary to obtain a piezoelectric material in the form of powder, the precursor solution is first calcined at a temperature of between 300°C and 450°C, and subsequently sintered at a temperature of 700-1200°C.

Further characteristics will emerge from the ensuing description of some merely illustrative and non-limiting examples.

### Example 1

### BZT-BCT in EG-HAc - Preparation and characterization

All the starting materials (barium acetate [Ba (CH₃COO)₂], calcium monohydrate [Ca(CH₃COO)₂•H₂O], tetrabutyl titanate [Ti(OC₄H₉)₄], and zirconium isopropoxide [Zr(OC₃H₇)₄] 70% sol in 1-propanol) were of analytical grade and were used without further purification.

Ethylene glycol and ethanol were used as solvents, whereas glacial acetic acid was used as chelating agent.

In the synthesis of the precursor solution, Ba-Ca and Ti-Zr solutions were produced separately.

The solution A was prepared by dissolving BaAc and CaAc separately in ethylene glycol at 70°C and then by stirring for 30 min.

The solutions were then mixed together at 100°C and stirred for 1 h to form the Ba-Ca solution.

For the solution B, to suppress hydrolysis on account of the environmental humidity of TiBut, an appropriate amount of glacial acetic acid was first added to the exactly weighed amount of TiBut, stirring for 20 min. Next, ZrIP was added and stirred at room temperature for 1 h to form Ti-Zr solution.

Finally, the solution B was mixed to the solution A, and ethanol was added up to the concentration of 0.4M, stirring for 3 h at room temperature to obtain a BZT-BCT precursor solution (BZT-BCT solution).

The BZT-BCT solution was then filtered through a PTFE syringe filter, 0.45 µm, and preserved in a glovebox.

The clear and colourless BZT-BCT solution obtained was stable and free from phenomena of precipitation or gelling.

Powders were then prepared by drying the precursor solution at 150°C for 24 h, leading to formation of a precipitated gel. The resulting gel was dried over night, and the solidified lumps were ground with a mortar and pestle to obtain fine powders.

The powders were then sintered at 950°C for 2 h to obtain formation of phase and to remove the non-reacted materials from the powders as synthesised.

The thermal behaviour of the powders of the white precursor deriving from the dried gel were analysed by DTA (Differential Thermal Analysis) in air atmosphere. The recordings were made by varying the temperature from room temperature to 1200°C, with a heating rate of 10°C/min.

The TGA curve (Figure 5) reveals a first loss of weight between room temperature and 300°C, with losses of 7% of the total weight, which may be attributed to evaporation of non-structural water and of the residual solvents. This causes an endothermic peak at 90°C.

The second loss of weight (∼25%) regards destruction of the lattice of the xerogel and subsequent loss of organic substances, as well as initial formation of BZT-0.5BCT.

The subsequent three exothermic peaks between 350°C and 550°C reveal the reactions of combustion and synthesis of intermediate products of reaction, i.e., Ti and Zr carbonates and oxides. The last peak at approximately 600°C shows an exothermic effect that may be put down to decomposition of BaCO₃ and CaCO₃ and hence to the reaction for formation of BZT-0.5BCT, with 5% losses of the total weight.

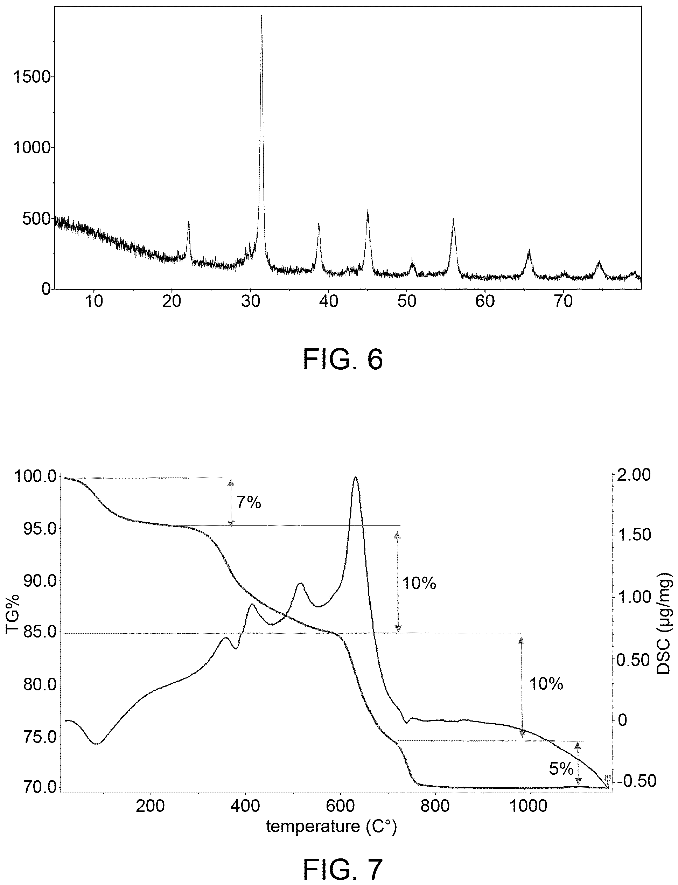

The XRD spectra (Figure 6) obtained from the sintered BZT-BCT powders (at 950°C) show the characteristic peaks of monophase perovskite. The absence of further peaks in the XRD data indicates the phase purity of the samples prepared and the efficiency of the synthesis and of the chemical procedures.

### Example 2

### BZT-BCT in EG-AcAc - Preparation and characterization

All the starting materials (barium acetate [Ba (CH₃COO)₂], calcium acetate monohydrate [Ca(CH₃COO)₂•H₂O], titanium isopropoxide, and zirconium isopropoxide [Zr(OC₃H₇)₄] 70% sol in 1-propanol) were of analytical grade and were used without further purification.

TiBut and ZrIP were accurately preserved and handled in a glovebox, but in nitrogen atmosphere with low humidity content.

Ethylene glycol was used as solvent, and acetylacetone was used as chelating agent in a molar ratio AcAc:[Ti+Zr] = 1.

In the synthesis of the precursor, Ba-Ca and Ti-Zr solutions were produced separately.

The solution A was prepared by dissolving separately BaAc and CaAc in ethylene glycol at 70°C and then stirring for 30 min.

The solutions were then mixed together at 100°C and stirred for 1 h to form the Ba-Ca solution.

For the solution B, TiIP and ZrIP were carefully added to AcAc and stirred for 30 min at 80°C in reflux conditions.

Finally, the two solutions A and B were mixed together and stirred at 120°C in reflux conditions to obtain a clear 0.4M solution, amber in colour.

The BZT-BCT precursor solution was then filtered through a PTFE syringe filter, 0.45 µm, and preserved in a glovebox.

The clear and colourless solution obtained was stable and free from phenomena of precipitation or gelling.

Powders were then prepared by drying the precursor solution at 150°C for 24 h, leading to formation of precipitated gel. The resulting gel was dried over night, and the solidified lumps were ground with a mortar and pestle to obtain fine powders.

The powders were then sintered at 950°C to obtain phase formation and to remove the non-reacted materials from the powders as synthesised.

The thermal behaviour of the powders of the white precursor deriving from the dried gel were analysed by means of DTA (Differential Thermal Analysis) in an air atmosphere. The recordings were made by varying the temperature from room temperature to 1200°C, with a heating rate of 10°C/min.

The TGA curve reveals a first loss of weight between room temperature and 300°C, with losses of approximately 7% of the total weight, which may be put down to evaporation of non-structural water and of the residual solvents. This causes a small endothermic peak at approximately 90°C.

The second loss of weight (10%) regards a destruction of the lattice of the xerogel and subsequent loss of organic substances, and initial formation of BZT-0.5BCT.

The subsequent three exothermic peaks between 350°C and 550°C reveal the reactions of combustion and synthesis of intermediate products of reaction, i.e., Ti and Zr carbonates and oxides.

The last peak at approximately 640°C shows an exothermic effect with approximately 10% of loss of weight that may be put down to decomposition of BaCO₃ and CaCO₃, and hence to the reaction for formation of BZT-0.5BCT. Formation of BZT-0.5BCT is completed at approximately 770°C, as illustrated in Figure 7.

The sintered powders and the sintered pellets were subjected to X-ray diffraction studies to confirm the phase formation.

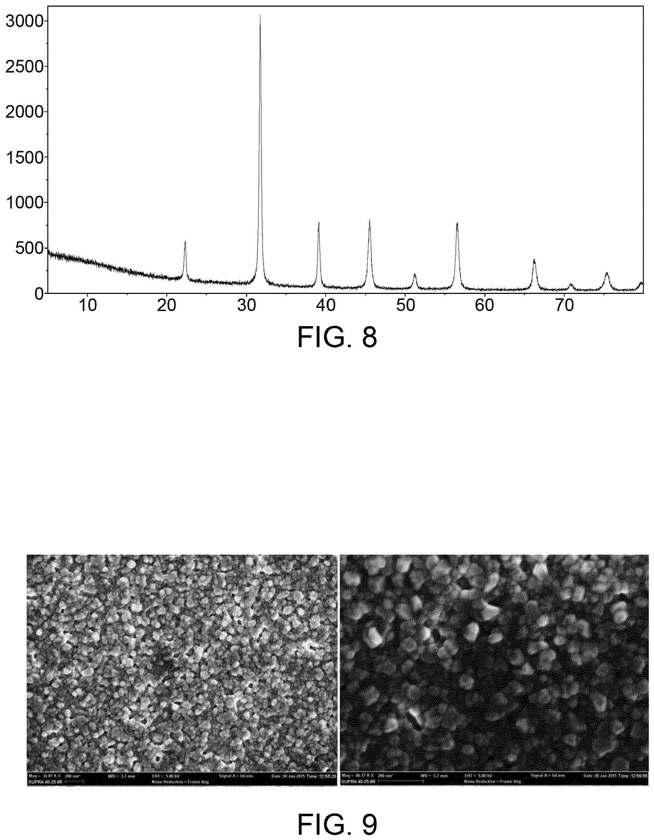

Figure 8 shows the X-ray diffraction spectrum of a sintered BZT-BCT sample. For both samples, a monophase tetragonal perovskite structure is evident in the XRD data at room temperature.

The absence of further peaks in the XRD data indicates the phase purity of the samples prepared and the efficiency of the synthesis and of the chemical procedures.

### Example 3

### BZT-BCT thin films (EG-HAc)

Presented hereinafter is an example of preparation of a thin film according to the invention, as well as its characterization.

Two thin films were prepared by depositing, by spin coating, the BZT-BCT solution (EG-HAc) at 2000 rpm for 40 s on clean platinum-coated silicon substrates. The deposited films were treated thermally at 150°C for 5 min and at 450°C for 5 min. This cycle was repeated to obtain films of different thicknesses. The films were re-baked in an oven at high temperature for 1 h at 850°C in air atmosphere.

The SEM images of the thin films obtained (appearing in Figure 9) show a dense film and grains with high uniformity.

A crystalline structure of the BZT-BCT thin films was characterized via X-ray diffraction. The XRD data on the thin films suggested a non-oriented perovskite structure.

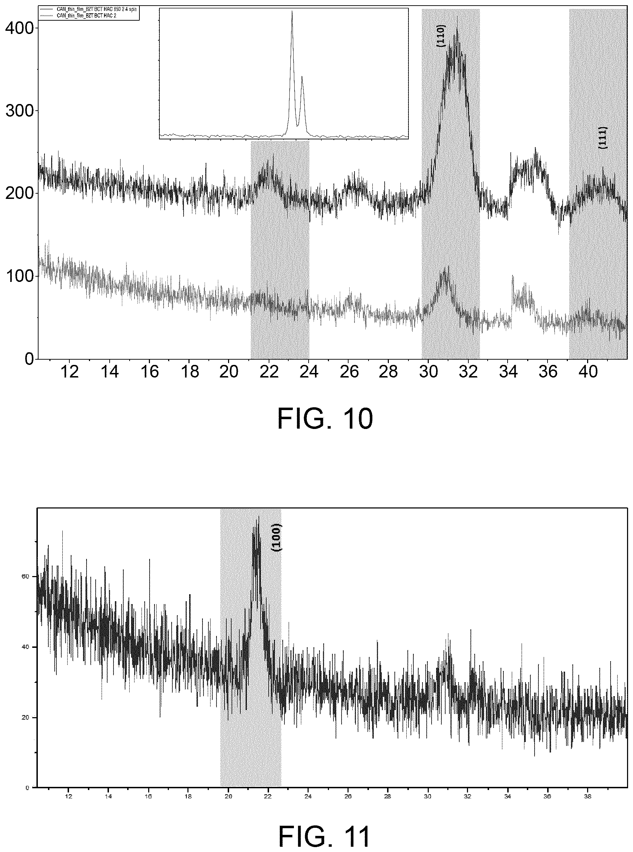

In Figure 10, the peaks at 22°, 32°, and 38° (top curve) are in fact visible with 2θ scanning (ω = 2°) for both of the thin films, i.e., the 1-spin (bottom curve), and the 4-spin (top curve), respectively. The peaks at 26° and 36° may be put down to the Si-TiO₂-Pt substrate.

The insert in Figure 10 shows the peak (100) with the components kα1 and kα2 of Cu radiation, at 2θ = 32°, and θ-2θ fast scanning (time per step = 2 s).

To improve the quality of crystallisation of the film a thin seed layer was inserted between the film and the Pt(111)/Ti/SiO₂/Si substrate using a sol-gel process. The crystalline structures of the thin films were analysed by XRD (2θ scanning, ω = 1°) as indicated in Figure 11. The monolayer thin films appeared to have mainly a (100) orientation.

## Claims

1. A precursor solution for the preparation of a ceramic of the BZT-αBXT type, where X is selected from Ca, Sn, Mn, and Nb, and α is a molar fraction selected in the range between 0.10 and 0.90, said solution consisting of:
1) at least one barium precursor compound;
2) at least one precursor compound selected from the group consisting of a calcium precursor compound, a tin precursor compound, a manganese precursor compound, and a niobium precursor compound;
3) at least one anhydrous precursor compound of zirconium;
4) at least one anhydrous precursor compound of titanium;
5) a solvent selected from the group consisting of propylene glycol, ethylene glycol, and 1,3-propanediol and optionally a secondary solvent selected from ethanol, 1-butanol, 1-propanol, 2-propanol, 2-butanol, isobutyl alcohol, 1-pentanol, 2-pentanol, 2-methyl-2-pentanol, acetic acid, n-butyric acid, x-methyl butyric acid, i-valeric acid, 2-ethyl butyric acid, 2,2-dimethyl butyric acid, 3,3-dimethyl butyric acid, 2,3-dimethyl butyric acid, 3-methylpentanoic acid, 4-methylpentanoic acid, 2-ethylpentanoic acid, 3-ethylpentanoic acid, 2,2-dimethylpentanoic acid, 3,3-dimethylpentanoic acid, 2,3-dimethylpentanoic acid, 2-ethylhexanoic acid, 3-ethylhexanoic acid, ethyl acetate, propyl acetate, n-butyl acetate, sec-butyl acetate, ter-butyl acetate, isobutyl acetate, n-amyl acetate, sec-amyl acetate, ter-amyl acetate, isoamyl acetate, acetone, methylethylketone, dimethyl ether, diethyl ether; and
6) a chelating agent and
7) optionally, a viscosizing agent selected from the group consisting of polyvinylpyrrolidone and polyethylene glycol,
wherein said precursor compounds of calcium, barium, zirconium, titanium, tin, niobium, and manganese are selected from the group consisting of metal alkoxides, metal-diol complexes, metal-thiol complexes, metal carboxylates, metal-3-diketonate complexes, metal-3-diketoester complexes, metal-3-iminoketo complexes, metal-amine complexes.

2. A precursor solution according to claim 1, **characterized in that** said barium precursor compound is selected from the group consisting of barium acetate and barium diisopropoxide.

3. A precursor solution according to claim 1, **characterized in that** said calcium precursor compound is selected from the group consisting of calcium acetate and calcium diisopropoxide.

4. A precursor solution according to claim 1, **characterized in that** said titanium precursor compound is selected from the group consisting of titanium tetraethoxide, titanium tetraisopropoxide, titanium tetra-n-butoxide, titanium tetraisobutoxide, titanium tetra-t-butoxide, and titanium dimethoxy diisopropoxide.

5. A precursor solution according to claim 1, **characterized in that** said zirconium precursor compound is selected from the group consisting of zirconium n-propoxide, zirconium tetraethoxide, zirconium tetraisopropoxide, zirconium tetra-n-butoxide, zirconium tetraisobutoxide, zirconium tetra-t-butoxide, and zirconium dimethoxy diisopropoxide.

6. A precursor solution according to claim 1, **characterized in that** said chelating agent is selected from the group consiting of acetylacetone (2,2-pentanedione, or AcAc), acetic acid (HAc), glycerol, propylene glycol, diethanolamine, EDTA (ethylenediaminetetraacetic acid), and triethanolamine.

7. A method for the preparation of a precursor solution according to any one of claims 1 to 6, comprising the steps of:
1) dissolving at least one barium precursor compound and at least one precursor compound selected from the group consisting of a calcium compound, a tin compound, a manganese compound, and a niobium compound, in a solvent selected from the group consisting of propylene glycol, ethylene glycol, and 1,3-propanediol to obtain a first solution;
2) dissolving at least one anhydrous compound of titanium and at least one anhydrous compound of zirconium in a chelating agent to obtain a second solution; and
3) mixing said first and second solutions to obtain said precursor solution
wherein said precursor compounds of calcium, barium, zirconium, titanium, tin, niobium, and manganese are selected from the group consisting of metal alkoxides, metal-diol complexes, metal-thiol complexes, metal carboxylates, metal-3-diketonate complexes, metal-3-diketoester complexes, metal-3-iminoketo complexes, metal-amine complexes.

8. A method for the preparation of a film of piezoelectric material made of a ceramic of the BZT-αBXT type, where X is selected from Ca, Sn, Mn, and Nb, and α is a molar fraction selected in the range between 0.10 and 0.90, said method comprising a step of depositing on a substrate a precursor solution according to any one of claims 1 to 6, a calcining step, and a sintering step.

## Patentansprüche

1. Vorläuferlösung zur Herstellung einer Keramik vom BZT-αBXT-Typ, wobei X aus Ca, Sn, Mn und Nb ausgewählt ist und α für einen Molenbruch im Bereich zwischen 0,10 und 0,90 steht, wobei die Lösung aus
1) mindestens einer Barium-Vorläuferverbindung;
2) mindestens einer Vorläuferverbindung aus der Gruppe bestehend aus einer Calcium-Vorläuferverbindung, einer Zinn-Vorläuferverbindung, einer Mangan-Vorläuferverbindung und einer Niob-Vorläuferverbindung;
3) mindestens einer wasserfreien Vorläuferverbindung von Zirconium;
4) mindestens einer wasserfreien Vorläuferverbindung von Titan;
5) einem Lösungsmittel aus der Gruppe bestehend aus Propylenglykol, Ethylenglykol und 1,3-Propandiol und gegebenenfalls ein sekundäres Lösungsmittel, das aus Ethanol, 1-Butanol, 1-Propanol, 2-Propanol, 2-Butanol, Isobutylalkohol, 1-Pentanol, 2-Pentanol, 2-Methyl-2-pentanol, Essigsäure, n-Buttersäure, x-Methylbuttersäure, i-Valeriansäure, 2-Ethylbuttersäure, 2,2-Dimethylbuttersäure, 3,3-Dimethylbuttersäure, 2,3-Dimethylbuttersäure, 3-Methylpentansäure, 4-Methylpentansäure, 2-Ethylpentansäure, 3-Ethylpentansäure, 2,2-Dimethylpentansäure, 3,3-Dimethylpentansäure, 2,3-Dimethylpentansäure, 2-Ethylhexansäure, 3-Ethylhexansäure, Essigsäureethylester, Essigsäurepropylester, Essigsäure-n-butylester, Essigsäure-secbutylester, Essigsäure-tert-butylester, Essigsäureisobutylester, Essigsäure-n-amylester, Essigsäure-sec-amylester, Essigsäure-tert-amylester, Essigsäureisoamylester, Aceton, Methylethylketon, Dimethylether, Diethylether ausgewählt ist; und
6) einem Chelatbildner und
7) gegebenenfalls einem Verdickungsmittel aus der Gruppe bestehend aus Polyvinylpyrrolidon und Polyethylenglykol
besteht, wobei die Vorläuferverbindungen von Calcium, Barium, Zirconium, Titan, Zinn, Niob und Mangan aus der Gruppe bestehend aus Metallalkoxiden, Metalldiolkomplexen, Metallthiolkomplexen, Metallcarboxylaten, Metall-3-diketonatkomplexen, Metall-3-diketoesterkomplexen, Metall-3-Iminoketokomplexen, Metallaminkomplexen ausgewählt sind.

2. Vorläuferlösung nach Anspruch 1, **dadurch gekennzeichnet, dass** die Barium-Vorläuferverbindung aus der Gruppe bestehend aus Bariumacetat und Bariumdiisopropoxid ausgewählt ist.

3. Vorläuferlösung nach Anspruch 1, **dadurch gekennzeichnet, dass** die Calcium-Vorläuferverbindung aus der Gruppe bestehend aus Calciumacetat und Calciumdiisopropoxid ausgewählt ist.

4. Vorläuferlösung nach Anspruch 1, **dadurch gekennzeichnet, dass** die Titan-Vorläuferverbindung aus der Gruppe bestehend aus Titantetraethoxid, Titantetraisopropoxid, Titantetra-n-butoxid, Titantetraisobutoxid, Titantetra-t-butoxid und Titandimethoxydiisopropoxid ausgewählt ist.

5. Vorläuferlösung nach Anspruch 1, **dadurch gekennzeichnet, dass** die Zirconium-Vorläuferverbindung aus der Gruppe bestehend aus Zirconium-n-propoxid, Zirconiumtetraethoxid, Zirconiumtetraisopropoxid, Zirconiumtetra-n-butoxid, Zirconiumtetraisobutoxid, Zirconiumtetra-t-butoxid und Zirconiumdimethoxydiisopropoxid ausgewählt ist.

6. Vorläuferlösung nach Anspruch 1, **dadurch gekennzeichnet, dass** der Chelatbildner aus der Gruppe bestehend aus Acetylaceton (2,2-Pentandion oder AcAc), Essigsäure (HAc), Glycerin, Propylenglykol, Diethanolamin, EDTA (Ethylendiamintetraessigsäure) und Triethanolamin ausgewählt ist.

7. Verfahren zur Herstellung einer Vorläuferlösung nach einem der Ansprüche 1 bis 6, das folgende Schritte umfasst:
1) Lösen mindestens einer Barium-Vorläuferverbindung und mindestens einer Vorläuferverbindung aus der Gruppe bestehend aus einer Calciumverbindung, einer Zinnverbindung, einer Manganverbindung und einer Niobverbindung in einem Lösungsmittel aus der Gruppe bestehend aus Propylenglykol, Ethylenglykol und 1,3-Propandiol zum Erhalt einer ersten Lösung;
2) Lösen mindestens einer wasserfreien Verbindung von Titan und mindestens einer wasserfreien Verbindung von Zirconium in einem Chelatbildner zum Erhalt einer zweiten Lösung und
3) Mischen der ersten Lösung und der zweiten Lösung zum Erhalt der Vorläuferlösung;
wobei die Vorläuferverbindungen von Calcium, Barium, Zirconium, Titan, Zinn, Niob und Mangan aus der Gruppe bestehend aus Metallalkoxiden, Metalldiolkomplexen, Metallthiolkomplexen, Metallcarboxylaten, Metall-3-diketonatkomplexen, Metall-3-diketoesterkomplexen, Metall-3-Iminoketokomplexen, Metallaminkomplexen ausgewählt werden.

8. Verfahren zur Herstellung eines Films von piezoelektrischem Material aus einer Keramik vom BZT-αBXT-Typ, wobei X aus Ca, Sn, Mn und Nb ausgewählt ist und α für einen Molenbruch im Bereich zwischen 0,10 und 0,90 steht, wobei das Verfahren einen Schritt des Abschneidens einer Vorläuferlösung nach einem der Ansprüche 1 bis 6 auf einem Substrat, einen Calcinierungsschritt und einen Sinterschritt umfasst.

## Revendications

1. Solution de précurseur pour la préparation d'une céramique du type BZT-αBXT, où le symbole X représente un atome choisi parmi Ca, Sn, Mn et Nb, et le nombre α est une fraction molaire choisie dans l'intervalle allant de 0,10 à 0,90, ladite solution étant constituée par :
1) au moins un composé précurseur de baryum,
2) au moins un composé précurseur choisi dans l'ensemble formé par un composé précurseur de calcium, un composé précurseur d'étain, un composé précurseur de manganèse et un composé précurseur de niobium,
3) au moins un composé anhydre précurseur de zirconium,
4) au moins un composé anhydre précurseur de titane,
5) un solvant choisi dans l'ensemble formé par du propylène-glycol, de l'éthylène-glycol et du 1,3-propanediol et, en option, un solvant secondaire choisi parmi les suivants: éthanol, 1-butanol, 1-propanol, 2-propanol, 2-butanol, alcool isobutylique, 1-pentanol, 2-pentanol, 2-méthyl-2-pentanol, acide acétique, acide n-butyrique, acide x-méthyl-butyrique, acide *i*-valérique, acide 2-éthyl-butyrique, acide 2,2-diméthyl-butyrique, acide 3,3-diméthyl-butyrique, acide 2,3-diméthyl-butyrique, acide 3-méthyl-pentanoïque, acide 4-méthyl-pentanoïque, acide 2-éthyl-pentanoïque, acide 3-éthyl-pentanoïque, acide 2,2-diméthyl-pentanoïque, acide 3,3-diméthyl-pentanoïque, acide 2,3-diméthyl-pentanoïque, acide 2-éthyl-hexanoïque, acide 3-éthyl-hexanoïque, acétate d'éthyle, acétate de propyle, acétate de n-butyle, acétate de sec-butyle, acétate de *tert*-butyle, acétate d'isobutyle, acétate de *n*-amyle, acétate de sec-amyle, acétate de *tert*-amyle, acétate d'isoamyle, acétone, méthyléthylcétone, éther diméthylique, éther diéthylique,
6) et un agent chélatant,
7) et, en option, un agent améliorant l'indice de viscosité choisi dans l'ensemble formé par de la polyvinylpyrrolidone et du polyéthylène-glycol, étant entendu que lesdits composés précurseurs de calcium, baryum, zirconium, titane, étain, niobium et manganèse sont choisis dans l'ensemble formé par des alcoolates de métal, complexes métal-diol, complexes métal-thiol, carboxylates de métal, complexes métal-3-dicétonate, complexes métal-3-dicétoester, complexes métal-3-iminocéto et complexes métal-amine.

2. Solution de précurseur conforme à la revendication 1, **caractérisée en ce que** ledit composé précurseur de baryum est choisi dans l'ensemble formé par de l'acétate de baryum et du di-isopropylate de baryum.

3. Solution de précurseur conforme à la revendication 1, **caractérisée en ce que** ledit composé précurseur de calcium est choisi dans l'ensemble formé par de l'acétate de calcium et du di-isopropylate de calcium.

4. Solution de précurseur conforme à la revendication 1, **caractérisée en ce que** ledit composé précurseur de titane est choisi dans l'ensemble formé par du tétra-éthylate de titane, du tétra-isopropylate de titane, du tétra-*n*-butylate de titane, du tétra-isobutylate de titane, du tétra-*tert*-butylate de titane et du diméthoxy-di-isopropylate de titane.

5. Solution de précurseur conforme à la revendication 1, **caractérisée en ce que** ledit composé précurseur de zirconium est choisi dans l'ensemble formé par du *n*-propylate de zirconium, du tétra-éthylate de zirconium, du tétra-isopropylate de zirconium, du tétra-*n*-butylate de zirconium, du tétra-isobutylate de zirconium, du tétra-*tert*-butylate de zirconium et du diméthoxy-di-isopropylate de zirconium.

6. Solution de précurseur conforme à la revendication 1, **caractérisée en ce que** ledit agent chélatant est choisi dans l'ensemble formé par de l'acétylacétone (2,2-pentanedione ou AcAc), de l'acide acétique (HAc), du glycérol, du propylène-glycol, de la diéthanolamine, de l'EDTA (acide éthylènediamine-tétra-acétique) et de la triéthanolamine.

7. Procédé pour la préparation d'une solution de précurseur conforme à n'importe laquelle des revendications 1 à 6, qui comporte les étapes suivantes :
1) dissolution d'au moins un composé précurseur de baryum et d'au moins un composé précurseur choisi dans l'ensemble formé par un composé de calcium, un composé d'étain, un composé de manganèse et un composé de niobium, dans un solvant choisi dans l'ensemble formé par du propylène-glycol, de l'éthylène-glycol et du 1,3-propanediol, de manière à produire une première solution,
2) dissolution d'au moins un composé anhydre de titane et d'au moins un composé anhydre de zirconium dans un agent chélatant, de manière à produire une deuxième solution,
3) et mélange desdites première et deuxième solutions de manière à préparer ladite solution de précurseur,
étant entendu que lesdits composés précurseurs de calcium, baryum, zirconium, titane, étain, niobium et manganèse sont choisis dans l'ensemble formé par des alcoolates de métal, complexes métal-diol, complexes métal-thiol, carboxylates de métal, complexes métal-3-dicétonates, complexes métal-3-dicétoester, complexes métal-3-iminocéto et complexes métal-amine.

8. Procédé pour la préparation d'un film de matériau piézoélectrique constitué d'une céramique du type BZT-αBXT, où le symbole X représente un atome choisi parmi Ca, Sn, Mn et Nb, et le nombre α est une fraction molaire choisie dans l'intervalle allant de 0,10 à 0,90, ledit procédé comprenant une étape de dépôt sur un support d'une solution de précurseur conforme à n'importe laquelle des revendications 1 à 6, une étape de calcination et une étape de frittage.
